Europäisches Patentamt

European Patent Office

Office européen des brevets

(11) Veröffentlichungsnummer: **0 136 644**
**A2**

(12) **EUROPÄISCHE PATENTANMELDUNG**

(21) Anmeldenummer: **84111371.5**

(22) Anmeldetag: **24.09.84**

(51) Int. Cl.⁴: **G 01 N 24/06**
**G 01 N 24/08**

(30) Priorität: **05.10.83 DE 3336286**

(43) Veröffentlichungstag der Anmeldung:
**10.04.85 Patentblatt 85/15**

(84) Benannte Vertragsstaaten:
**DE FR GB NL**

(71) Anmelder: **Siemens Aktiengesellschaft**
**Berlin und München Wittelsbacherplatz 2**
**D-8000 München 2(DE)**

(72) Erfinder: **Kestler, Joachim**
**Judengasse 4**
**D-8551 Pretzfeld(DE)**

(54) **Gerät zur Erzeugung von Bildern eines Untersuchungsobjektes mit magnetischer Kernresonanz.**

(57) Die Erfindung betrifft ein Gerät zur Erzeugung von Bildern eines Untersuchungsobjektes mit magnetischer Kernresonanz, bei dem Mittel zum Anlegen von Magnetfeldern an das Untersuchungsobjekt und zum Erfassen der Auslenkung der Atomkerne des Untersuchungsobjektes aus ihrer Gleichgewichtslage durch eine hochfrequenten, magnetischen Anregungsimpuls vorhanden sind. Die Mittel zum Anlegen von Magnetfeldern enthalten wenigstens eine Gradientenspule (5) zur Erzeugung eines linearen, magnetischen Feldgradienten. Die Gradientenspule (5) ist in Reihe mit einer Zusatzinduktivität (20) an ihrer Stromquelle (29) angeschlossen. In Reihe mit der Gradientenspule (5) liegt ein erster Schalter (21). Parallel zu dieser Reihenschaltung (5, 21) ist ein etwa gleichzeitig mit dem ersten Schalter (21) betätigbarer zweiter Schalter (22) geschaltet.

FIG 2

SIEMENS AKTIENGESELLSCHAFT

Berlin und München

Unser Zeichen

VPA 83 P 3 3 4 3 E

### Gerät zur Erzeugung von Bildern eines Untersuchungsobjektes mit magnetischer Kernresonanz

Die Erfindung betrifft ein Gerät zur Erzeugung von Bildern eines Untersuchungsobjektes mit magnetischer Kernresonanz, bei dem Mittel zum Anlegen von Magnetfeldern an das Untersuchungsobjekt und zum Erfassen der Auslenkung der Atomkerne des Untersuchungsobjektes aus ihrer Gleichgewichtslage durch einen hochfrequenten, magnetischen Anregungsimpuls vorhanden sind, wobei die Mittel zum Anlegen von Magnetfeldern wenigstens eine Gradientenspule zur Erzeugung eines linearen, magnetischen Feldgradienten aufweisen.

Es ist bekannt, daß man insbesondere die Wasserstoffatomkerne eines Untersuchungsobjektes aus einer Vorzugsrichtung, die durch ein Magnet-Grundfeld erzeugt wird, durch einen hochfrequenten Anregungsimpuls auslenken kann und daß sich die Atomkerne nach dem Ende dieses Anregungsimpulses aufgrund ihres Spins erst nach einer gewissen Zeit wieder in die Vorzugsrichtung einpendeln. Während dieser Zeit präzedieren die Atomkerne mit einer Frequenz, die von der Stärke des Magnet-Grundfeldes abhängt. Überlagert man diesem homogenen Magnet-Grundfeld einen Feldgradienten, so daß die Magnetfeldverteilung räumlich variiert, so ist eine Ortung über die jeweils gemessene Frequenz möglich. Es ist auch bekannt, daß man auf diese Weise und durch Änderung der Richtung des Feldgradienten Schichtbilder des Untersuchungsobjektes anfertigen kann. Die Anregung in einer Schicht des Untersuchungsobjektes erfolgt dabei dadurch, daß das Magnet-Grundfeld durch einen weiteren Feldgradienten so

Tp 2 Ler / 24.08.1983

beeinflußt wird, daß nur in dieser Schicht eine Anregung der Atomkerne erfolgt. Dies ist möglich, weil die Anregung nur mit einer Frequenz erfolgt, die dem Magnetfeld in der gewünschten Schicht streng zugeordnet ist.

In den Gradientenspulen zur Erzeugung der Feldgradienten treten in der Praxis Spulenströme im Bereich von 5 Ampere bis 300 Ampere auf, die relativ rasch ein- und ausschaltbar sein müssen. Damit keine Bildstörungen auftreten, müssen die Stromimpulse in den Gradientenspulen eine exakt vorgegebene Form (flaches Dach) und einen reproduzierbaren Verlauf der Schaltflanken aufweisen.

Der Erfindung liegt die Aufgabe zugrunde, ein Gerät der eingangs genannten Art so auszubilden, daß die oben geschilderten Forderungen hinsichtlich der Stromimpulse in den Gradientenspulen auf einfache Weise erfüllbar sind.

Diese Aufgabe ist erfindungsgemäß dadurch gelöst, daß die Gradientenspule in Reihe mit einer Zusatzinduktivität an ihrer Stromquelle angeschossen ist, und daß in Reihe mit der Gradientenspule ein erster Schalter sowie parallel zu dieser Reihenschaltung ein etwa gleichzeitig mit dem ersten Schalter betätigbarer zweiter Schalter liegt. Der Erfindung liegt der Gedanke zugrunde, die für einen schnellen Stromanstieg in der Gradientenspule erforderliche Übererregung dadurch zu erzeugen, daß die hierfür kurzzeitig erforderliche hohe Spannung aus einer stromdurchflossenen Induktivität entnommen wird.

Die Erfindung ist nachfolgend anhand eines in der Zeichnung dargestellten Ausführungsbeispieles näher erläutert. Es zeigen:

0136644

Fig. 1 ein Gerät zur Erzeugung von Bildern eines
Untersuchungsobjektes mit magnetischer Kernresonanz,

Fig. 2 eine Schaltung zur Erzeugung des Stromes in
einer Gradientenspule,

Fig. 3 und 4 Kurven zur Erläuterung der Figur 2,
und

Fig. 5 ein detailliertes Schaltbild zur Stromversorgung einer Gradientenspule.

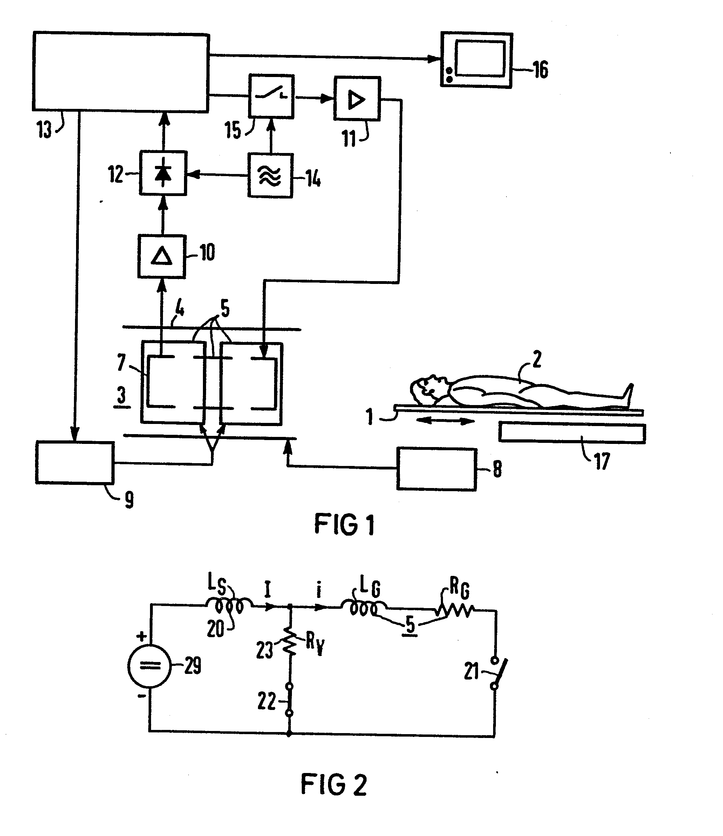

In der Figur 1 ist eine Auflage 1 dargestellt, auf der
ein Patient 2 liegt, von dem mit Hilfe magnetischer Kernresonanz Bilder erzeugt werden sollen. Hierzu sind ein
Spulensystem 3 mit einer Spule 4 zur Erzeugung eines
homogenen Magnet-Grundfeldes und Gradientenspulen 5 zur
Variierung dieses Magnet-Grundfeldes sowie mit einer
Anregungs- und Meßspule 7 vorhanden. Die Spule 4 ist an
einer Magnet-Stromversorgung 8, die Gradientenspulen 5
sind an einer Gradienten-Stromversorgung 9, die Anregungs- und Meßspule 7 ist an einem Vorverstärker 10 und
über entsprechende Koppelelemente an einem Sendeverstärker 11 angeschlossen. Der Vorverstärker 10 führt das
Meßsignal über einen phasenempfindlichen Gleichrichter
12 einem Prozeßrechner 13 zu, der den gesamten Meßvorgang steuert. Zur Erzeugung eines Anregungsimpulses
dient ein Hochfrequenzoszillator 14, der über einen
Modulator 15 an den Sendeverstärker 11 anschaltbar ist.
Die Wiedergabe der erzeugten Bilder erfolgt auf einem
Monitor 16.

Zur Erzeugung eines Bildes des Patienten 2 mit Hilfe
magnetischer Kernresonanz wird die Auflage 1 mit Hilfe einer Steuervorrichtung 17, die ebenfalls vom Prozeßrechner 13 angesteuert wird, so in das Spulensystem
eingeschoben, daß eine bestimmte Schicht des Patienten
2 so liegt, daß aufgrund des erzeugten Magnetfeldes
dort durch einen Anregungsimpuls in der Spule 7 Kernresonanz angeregt wird. Aus dem ebenfalls mit Hilfe der
Spule 7 aufgenommenen Meßsignal werden Informationen gebildet, aus denen ein Bild der angeregten Schicht berechnet und auf dem Monitor 16 wiedergegeben werden
kann. Zur Bilderzeugung ist eine Änderung der Feldgradienten und damit eine Ein- und Ausschaltung der Gradientenspulen 5 erforderlich.

In der Figur 2 ist eine Schaltung zur Stromversorgung
einer Gradientenspule 5 dargestellt. Von der Gradientenspule 5 sind dabei die Induktivität $L_G$ und der ohm'-
sche Widerstand $R_G$ gezeichnet. Die Gradientenspule 5
ist in Reihe mit einer Zusatzinduktivität 20 an ihrer
Gleichstromquelle 29 angeschlossen. In Reihe mit der
Gradientenspule 5 liegt ein erster Schalter 21 und parallel zu dieser Reihenschaltung 5, 21 ist ein Schalter
22 angeordnet, der mit einem ohm'schen Widerstand 23 in
Reihe liegt. Die Zusatzinduktivität 20 hat die Induktivität $L_S$ und der Widerstand 23 den Widerstandswert $R_V$.
Der Widerstandswert $R_V$ wird vorzugsweise ebenso groß
gewählt wie der Widerstand $R_G$ der Gradientenspule 5.

Der Gradientenstrom i wird durch Schließen des Schalters 21 und gleichzeitiges Öffnen des Schalters 22 eingeschaltet. Die in der Zusatzinduktivität 20 gespeicherte Energie verteilt sich beim Umschalten auf beide Induktivitäten $L_S$ und $L_G$, wobei die zur Übererregung der
Gradientenspule 5 notwendige Spannungsspitze entsteht.

Für den Gradientenstrom i ergibt sich unmittelbar nach
dem Umschalten:

$$i_0 = I \times \frac{L_S}{L_S + L_G}$$

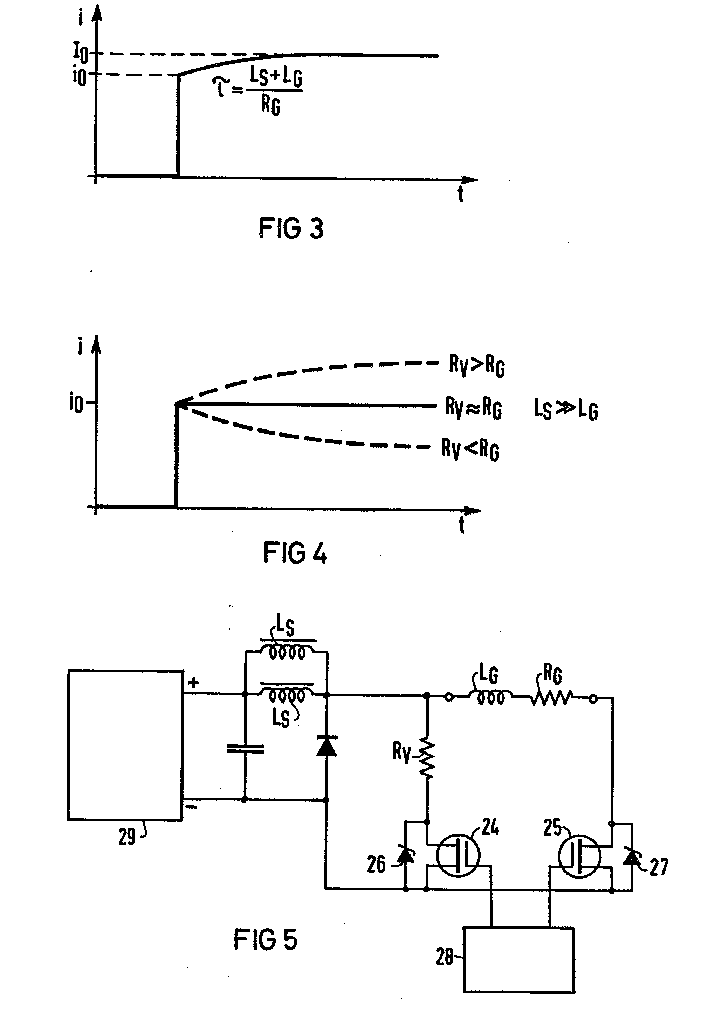

Die Stromverläufe sind in der Figur 3 dargestellt. Der nicht ideale weitere Verlauf von $i$ läßt sich auf zweierlei Art vermeiden: Macht man $L_S$ wesentlich größer als $L_G$, dann geht $i_0$ gegen $i$. Außerdem kann $R_V$ etwas kleiner als $R_G$ gewählt werden, so daß der Strom durch $L_S$ vor dem Umschalten um den erforderlichen Betrag größer ist:

$$\frac{R_V}{R_G} = \frac{L_S}{L_S + L_G}$$

Durch die Wahl des Vorwiderstandes $R_V$ kann man also den zeitlichen Stromverlauf in gewissen Grenzen variieren (Fig. 4), die Zeitkonstante $\tau$ ist über $L_S$ einstellbar:

$$\tau = \frac{L_S + L_G}{R_G}$$

Auf diese Weise läßt sich auch eine Wirbelstromkompensation durchführen.

Das Abschalten des Gradientenstromes wird durch Öffnen des Schalters 21 und gleichzeitiges Schließen des Schalters 22 ausgeführt. Dabei entsteht am Schalter 21 eine Spannungsspitze, die für raschen Feldabbau in $L_G$ notwendig ist.

Die Figur 5 zeigt den Schaltplan eines Ausführungsbeispieles. Um bessere thermische und zeitliche Stabilität der Impulsamplitude zu erreichen, ist als Stromquelle 29 hier eine Konstantstromquelle vorgesehen. Als Schalter
sind Transistoren 24, 25 gewählt; die parallelgeschalteten Zenerdioden 26, 27 begrenzen die Spannungsspitzen
beim Ein- und Ausschalten des Gradientenstromes, was
einen ausreichend raschen Anstieg und Abfall des Stromes ermöglicht. Die Ansteuerung der Transistoren 24,
25 erfolgt durch eine Steuerlogik 28.

2 Patentansprüche
5 Figuren

Patentanprüche

1. Gerät zur Erzeugung von Bildern eines Untersuchungsobjektes (2) mit magnetischer Kernresonanz, bei dem Mittel (3) zum Anlegen von Magnetfeldern an das Untersuchungsobjekt (2) und zum Erfassen der Auslenkung der Atomkerne des Untersuchungsobjektes (2) aus ihrer Gleichgewichtslage durch einen hochfrequenten, magnetischen Anregungsimpuls vorhanden sind, wobei die Mittel (3) zum Anlegen von Magnetfeldern wenigstens eine Gradientenspule (5) zur Erzeugung eines linearen, magnetischen Feldgradienten aufweisen, d a d u r c h g e k e n n z e i c h n e t , daß die Gradientenspule (5) in Reihe mit einer Zusatzinduktivität (20) an ihrer Stromquelle (29) angeschlossen ist, und daß in Reihe mit der Gradientenspule (5) ein erster Schalter (21) sowie parallel zu dieser Reihenschaltung (5, 21) ein etwa gleichzeitig mit dem ersten Schalter (21) betätigbarer zweiter Schalter (22) liegt.

2. Gerät nach Anspruch 1, d a d u r c h g e k e n n z e i c h n e t , daß in Reihe mit dem zweiten Schalter (22) ein ohm'scher Widerstand (23) geschaltet ist.

FIG 1

FIG 2

$$\tau = \frac{L_S + L_G}{R_G}$$

FIG 3

$R_V > R_G$

$R_V \approx R_G$     $L_S \gg L_G$

$R_V < R_G$

FIG 4

FIG 5